# EUROPEAN PATENT APPLICATION

(11) **EP 2 597 695 A1**
(43) Date of publication of application: **29.05.2013**
(21) Application number: 11306570.0
(22) Date of filing: 25.11.2011
(51) Int. Cl.: H01L 51/42

(54) **Electroactive surfactant improved hybrid bulk heterojunction solar cells**

(71) Applicant: Centre National de la Recherche Scientifique (C.N.R.S), 75016 Paris (FR); Université d'Aix-Marseille, 13284 Marseille Cedex 07 (FR)
(72) Inventor: Ackermann, Jörg, 13008 MARSEILLE (FR); Wang, Mingqing, 13009 MARSEILLE (FR)
(74) Representative: Blot, Philippe Robert Emile

(57) **Abstract**

The present invention is directed to a hybrid heterojunction comprising a conjugated polymer and semiconductor nanocrystals, wherein the semiconductor nanocrystals are grafted with up to 3% by weight of an electroactive surfactant whose LUMO level is lower than or equal to the LUMO level of the conjugated polymer and higher than or equal to the conducting band level of the semiconductor nanoparticles. It also concerns solar cells comprising such hybrid junctions as well as a process for their manufacture.

## Description

### [Introduction]

This application concerns components for capturing solar energy, in particular hybrid heterojunctions comprising a polymer and semiconductor nanocrystals, wherein the semiconductor nanocrystals are grafted with an electroactive surfactant.

### [State of the art]

Solar cells based on organic conjugated polymers and inorganic semiconductor nanocrystals, also called hybrid solar cells, may combine interesting photoelectric properties of bulk inorganic materials with advantages of polymers such as solution processability and low-temperature chemical synthesis.

These advantages make them good candidates as materials in solar cells for clean, renewable and low-cost energy generation.

Different semiconductor nanocrystals such as CdSe, TiO₂ and ZnO have been used to prepare hybrid solar cells. However, the photovoltaic performance is not always satisfactory.

Alivisatos *et al.* used CdSe nanorods or tetrapods to enhance carrier transport routes (W.U. Huynh, J.J. Dittmer, A.P. Alivisatos, Science 2002, 295, 2425 and I. Gur, N.A. Fromer, C.P. Chen, A.G. Kanaras, A.P. Alivisatos, Nano Lett. 2007, 7, 409). Their results have shown that improvement in power conversion efficiency can be achieved by reducing the number of interparticle hopping. However, the elaborate, high temperature synthesis and the toxicity of CdSe motivate the search for alternative materials.

R. Janssen et al used ZnO nanospheres and nanorods blended with conjugated polymers, but the efficiency of these devices was still low (W.J.E. Beek, M. M. Wienk, M. Kemerink, X. Yang, R. A. J. Janssen, J. Phys. Chem. B. 2005, 109, 9505).

One major problem related to polymer-nanoparticle blends is the dispersion of the nanoparticle inside the polymer so that a bulk heterojunction is formed with a large polymer-nanoparticle interface and an interconnected network of nanoparticles that ensures an efficient electron transport towards the cathode of the solar cell. Often, the nanoparticles tend to aggregate due to a low compatibility with the solvent. The surface modification of the nanoparticles with surfactants can increase their solubility. Indeed, Janssen et al. have shown that using n-propylamine, i.e. organic isolator, as surfactant increases solubility of ZnO nanoparticles, but their use reduces the photovoltaic properties of P3HT:ZnO blends, although increasing the dispersion of nanoparticles inside the polymer (W.J.E. Beek, M. M. Wienk, M. Kemerink, X. Yang, R. A. J. Janssen, J. Phys. Chem. B. 2005, 109, 9505). Ackermann et al. have shown that using surfactant such as porphyrines lead to additional light absorption but introduced aggregation among ZnO nanorods due to pi-pi interaction of parallel oriented molecules (Said, A. J.; Poize, G.; Martini, C.; Ferry, D.; Marine, W.; Giorgio, S.; Fages, F.; Hocq, J.; Bouclé, J.; Nelson, J.; Durrant, J.; Ackermann, J. J. Phys. Chem. C. 2010, 114, 11273). Chen *et al.* recently also used TiO₂ nanorods modified by ligand molecules as electron acceptor in combination with P3HT (Y.Y. Lin, T.U. Chu, S.S. Li, C.H. Chuang, W.F. Su, C.P. Chang, M.W. Chu, C.W. Chen. J. Am. Chem. Soc. 2009, 131, 3644). Their results showed an improvement in the power conversion efficiency of a P3HT/TiO₂ nanorod hybrid solar cell related to a reduction of charge carrier recombination by the presence of the ligand at the nanorod surface, but no improved nanorod solubility due to the ligand modification was reported. These ligands do not bear solubilizing groups.

### [Summary of the invention]

According to a first aspect, the invention thus proposes a hybrid heterojunction comprising a conjugated polymer and semiconductor nanocrystals, wherein the semiconductor nanocrystals are grafted with up to 3% by weight of an electroactive surfactant whose LUMO level is lower than or equal to the LUMO level of the conjugated polymer and higher than or equal to the conducting band level of the semiconductor nanoparticles.

The conjugated polymer is preferably derived from polythiophene, in particular poly (3-hexylthiophene).

The semiconductor nanocrystals are advantageously of ZnO. They may be in particular nanospheres or elongated nanoparticles.

The electroactive surfactant carries preferably a carboxylic acid moiety at a terminal position and is advantageously a conjugated molecule. Preferably, the electroactive surfactant carries a carboxylic moiety and/or a tertiary amine group at a terminal position. Further, it may comprise at least one thiophene moiety and/or a cyano group, the latter preferably in α-position to the carboxylic moiety, if any.

The semiconductor nanocrystals are preferably grafted with between 0.01 % and 2% by weight of electroactive surfactant, with respect to the weight of the semiconductor.

According to a second aspect, the invention is directed to solar cells comprising a hybrid heterojunction as proposed.

According to a last aspect, the invention is directed to a process for the manufacture of a hybrid heterojunction comprising a conjugated polymer and semiconductor nanocrystals grafted with an electroactive surfactant comprising a conjugated polymer and semiconductor nanocrystals grafted with an electroactive surfactant, comprising the steps consisting of:
(i) dispersing the semi-conductor nanocrystals into a suitable solvent;
(ii) mixing the electroactive surfactant in an amount of up to 3 wt%, with respect to the weight of the nanocrystals, said surfactant being optionally dissolved in a suitable solvent, with the dispersion obtained in step (i) and stirring the solution to obtain semiconductor nanocrystals grafted with electroactive surfactant;
(iii) mixing with a suitable quantity of a conjugated polymer;
(iv) preparing a film of the mixture; and
(v) evaporating the solvent.

### [Detailed Description of the invention]

### [Hybrid heterojunction]

The hybrid heterojunction comprises an electron acceptor material and an electron donor material, one being an organic compound and the other an inorganic compound.

The semiconductor nanocrystals used as an electron acceptor represent the inorganic component of the hybrid heterojunction according to the invention.

The semiconductor nanocrystals preferably comprise or are made of oxides or sulfides of transition metals. Particularly preferred are semiconductor nanocrystals comprising or made of ZnO. Indeed, ZnO is transparent, non toxic and easily available at a low cost. The semiconductor nanocrystals however also may comprise also or be made of TiO₂ or other low band gap n-type materials such as Bi₂S₃. However, ZnO nanoparticles are preferred as ZnO has a low crystallization temperature and disperses well in organic solvents.

The nanocrystals may have different forms.

In particular, the semiconductor nanocrystals may be elongated or otherwise anisotropic. Examples of elongated nanocrystals are nanorods, nanowires, nanotetrapods, nanomultipods and nanocones. Elongated nanocrystals may be preferred since they show better charge transport due to reduction of number of interfacial transport events between nanocrystal compared nanospheres along the same distance. Interfaces between nanoparticles represent charge transport barriers and reduce the charge carrier mobility.

The semiconductor nanocrystals may also be spherical or otherwise isotropic. Spherical nanocrystals may be preferred for some embodiments of the invention because they disperse well in organic solvents and have a low tendency to form agglomerates. According to the invention, the semiconductor nanocrystals used for the hybrid heterojunction are coated with an electroactive surfactant.

The electroactive surfactant is used to modify the surface of semiconductor nanocrystals in order to increase the dispersion of the nanocrystals within the organic component, thus to increase the interface available for transfer reactions. Additionally, the electroactive surfactant may improve charge carrier injection from the polymer towards the nanocrystals and reduce corresponding recombination reactions.

The term "electroactive surfactant" is intended to mean within the present application a compound which allows for charge transport between the polymer and the nanoparticle and thus is not an isolator and which bears solubilizing groups so as to ensure a good compatibility of the nanoparticles with the solvent and the polymer. The electroactive surfactant is preferably a π-conjugated molecule (organic semiconductor). According to the invention, the electroactive surfactant has a lowest unoccupied orbital (LUMO) level located at an energy level which is between the LUMO level of the polymer and the conducting band level of the nanoparticle, or equal to one or both of these levels. Indeed, such a configuration allows cascade charge transfer reactions to occur between the donor polymer and the nanoparticles. Finally, the electroactive surfactant may also contain moieties such as thiophene groups, which are also present in the polymer in order to improve its chemical compatibility with the polymer and thus the charge transport towards the nanostructure.

Using semiconductor nanocrystals coated with electroactive surfactants improves the dispersion of ZnO nanocrystals in the polymer through the formation of a high solubility shell around the nanorods. This improves the homogeneity of the material and contributes to improve control over the morphology of the polymer/ nanocrystals nanocomposite.

As a consequence, the measured I-V (current vs. voltage) curves of devices made of semi-conductor nanocrystals coated with electroactive surfactants show an improvement in the photovoltaic properties. In particular, the short circuit current Isc increases strongly and by consequence in the device efficiency η under AM 1.5 conditions.

Additionally, the open circuit voltage is improved. This is due to a reduction of semi-conductor nanoparticle aggregates in the blend which usually leads to short circuit reducing the Voc. Furthermore the surfactant may reduce possible short circuit by avoiding direct contact between the nanoparticles and the anodes which also increases the Voc. The grafting of the electroactive surfactant may also reduce charge recombination at the hybrid interface. The incident photon to current conversion efficiency (IPCE) of the cells using modified nanorods show improved values compared to the reference cells indicating a strong impact of the surfactant on the photocurrent generation.

Preferred electroactive surfactants within the present invention are organic compounds that possess one or more carboxyl groups, preferably located at the terminal end of the molecule. Indeed, the terminal carboxyl group may strongly attach to the semiconductor nanocrystals surface.

In most cases, the electroactive surfactant comprises three spatially separated groups, that is a donor group, a receptor group and a linker group, as depicted in the schematic representation below:

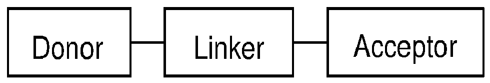

The linker group is preferably a conducting moiety, for instance a pi-conjugated group. Preferably, one of the donor or acceptor groups comprises non polar moieties, for instance an aryldialkylamine group which may act as a solubilizing group in non polar solvents. Preferably, one of the donor or acceptor groups comprises polar moieties, for instance one or more alkoxy groups, which may act as a solubilizing group in a polar solvent. The other group respectively may comprise polar moieties, such as a carboxylic acid, thiol or phosphonic groups that have an affinity to the semi-conductor and thus may act as an attaching group.

Particularly preferred electroactive surfactants are compounds according to formula (I): 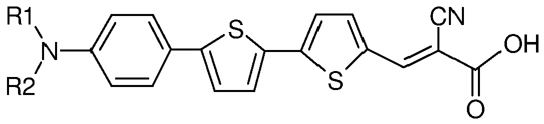 wherein R1 and R2 may be different or identical and may represent :
an aliphatic or aromatic hydrocarbon eventually substituted or interrupted by O, S, N or P, preferably an straight or branched alkyl group with 1 to 12 carbon atoms or a aromatic cycle, in particular a benzene, substituted in o-, p- or m-position by a OR3 group, wherein R3 may be hydrogen or an straight or branched alkyl group comprising 1 to 12 carbon atoms, where R1 and R2 may be connected, in particular, in case R1 and/or R2 is benzene by a bond in ortho-position.

Particularly preferred electroactive surfactants are molecules containing building blocks well known for high mobility charge transport such as oligothiophenes, carbazole, benzenes etc. The following compounds are suitable:
- Dimethoxycarbazole-bithiophene (DMC2T)
- Dibutylcarbazole-bithiophene (DBC2T)
- (2E)-2-cyano-3-(5'-{(E)-2-[4-(dimetylamino)phenyl]vinyl}-2,2'-bithien-5-yl)acrylic acid and piperidine (PS67P);
- (2E)-2-cyano-3-(5'-{(E)-2-[4-(dibutylamino)phenyl]vinyl}-2,2'-bithien-5-yl)acrylic acid (PS-65);
- (dimethoxycarbazole-bithiophene) and piperidine (DMC2TP);
- Dibutylcarbazole-bithiophene and piperidine (DBC2TP);
- (2E)-2-cyano-3-(5'-{(E)-2-[4-(dibutylamino)phenyl]vinyl}-2,2'-bithien-5-yl)acrylic acid and piperidine (PS65P) ;
- (2E)-2-cyano-3-(5'-{(E)-2-[4-(dimetylamino)phenyl]vinyl}-2,2'-bithien-5-yl)acrylic acid (PS67).

Some compounds were used with small residual quantities of piperidine.

The compounds have the following chemical formula, respectively:

| | |
|---|---|
| 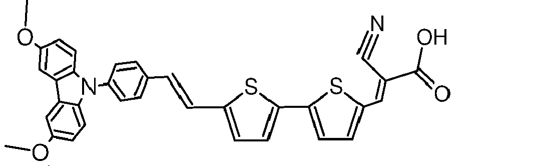 | DMC2T |
| 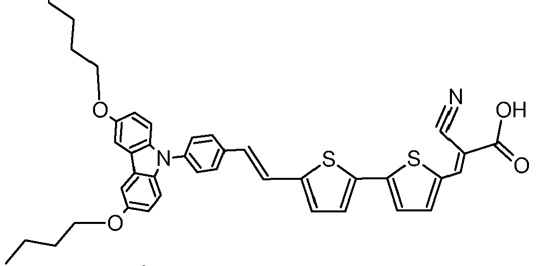 | DBC2T |
| 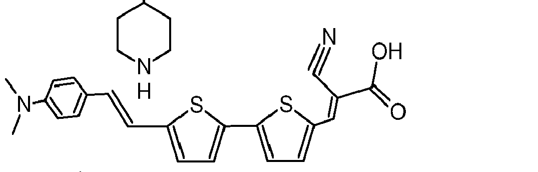 | PS67P |
| 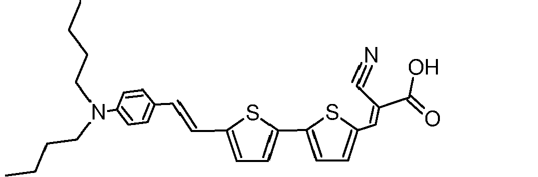 | PS65 |
| 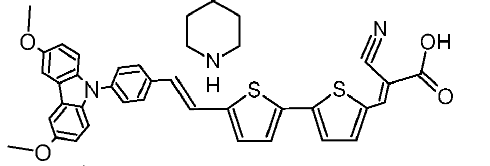 | DMC2TP |
| 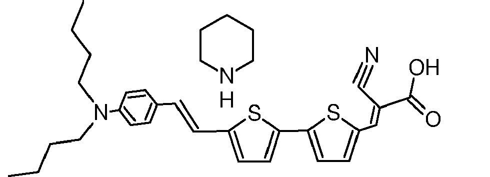 | PS65P |
| 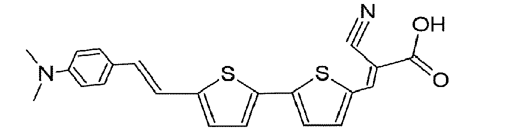 | PS67 |

The synthesis of compound DMC2T is described in the scheme 1 below:

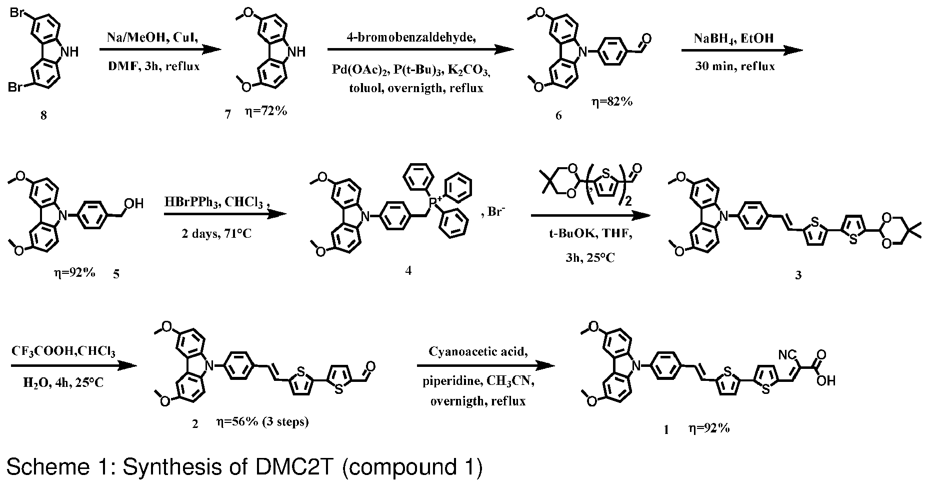

The synthesis of compound (1) (DMC2T) was carried out in seven stages (presented in Scheme 1). The first step produces compound 7 (3,6-dimethoxy-9H-carbazole) from compound 8 (3,6-dibromo-9H-carbazole) by the procedure described in the literature (Holzapfel, M.; Lambert, C. J. Phys. Chem. C, 2008, 112 (4), 1227-1243)). in the presence of Cul in dimethylformamide followed an addition of MeONa. Compound 7 is obtained with a yield of 72%. By doing a Suzuki type coupling between the latter and 4-bromobenzaldehyde, compound 6 4-(3,6-dimethoxy-9H-carbazol-9-yl) benzaldehyde is obtained with a yield of 82%. The third step is a reduction reaction of the aldehyde 6 in the presence of NaBH₄ leading to the alcohol 5 (4-(3,6-dimethoxy-9H-carbazol-9-yl) phenyl) methanol) with a yield of 92%. The latter is used in the presence of HBrPPh₃ in chloroform for a two day reaction to synthesis the phosphonium compound 4 (4-(3,6-dimethoxy-9H-carbazol-9-yl)benzyl)triphenylphosphonium bromide) followed by reaction of Wittig between phosphonium **4** and bithiophene (5'-(5,5-dimethyl-1,3-dioxan-2-yl)-2,2'-bithiophene-5-carbaldehyde) to prepare compound **3**. Deprotection of compound **3** in the presence of CF₃COOH acid in chloroform leads to the aldehyde **2** ((E)-5'-(4-(3,6-dimethoxy-9H-carbazol-9-yl)styryl)-2,2'-bithiophene-5-carbaldehyde) with a yield of 56% for the three stages. The final step occurs in acetonitrile by addition of cyanoacetic acid to compound **2** in the presence of piperidine to give the compound **1** ((E)-2-cyano-3-(5'-(4-(3,6-dimethoxy-9H-carbazol-9-yl)styryl)-2,2'-bithiophene-5-yl)acrylic acid), named **DMC2T**, with a yield of 92%.

Generally, the semiconductor nanocrystals are grafted with the electroactive surfactant prior to being mixed with the electron donor component, but the grafting may be done also at the same time by mixing the nanocrystals, surfactant and polymer together.

Grafting is obtained by simply mixing the nanocrystals with the electroactive surfactant in a suitable solvent. Grafting of the electroactive surfactant onto the surface of the semiconductor nanocrystals then occurs readily.

Suitable solvents for the grafting are those which are capable of dispersing the nanoparticles and which also show an affinity with the solubilizing groups of the electroactive solvent. For above indicated electroactive solvents, chlorinated aromatic or aliphatic hydrocarbons, such as chlorobenzene or chloroform. Additionally, alcoholic solvents such as ethanol and glycols such as ethyleneglycol or mixture of both alcoholic and glycols as well as aliphatic hydrocarbons such as heptane or hexane have been found satisfactory solvents.

For obtaining the positive effects indicated above, the electroactive surfactant is preferably used in a solution having a concentration of up to 3 wt%, preferably 0,01 to 2 wt% with respect to the weight of the ZnO nanoparticles. Preferably, the electroactive surfactant is used at a concentration of up to 2 wt%. The coated nanocrystals may then by further processed by mixing with a suitable organic electron donor to form the hybrid heterojunction.

Preferably, the final hybrid heterojunction comprises 40 to 90, in particular 50 to 80 and preferably 60 to 70 % by weight of grafted semiconductor nanocrystals.

The electroactive surfactant modified nanoparticles, eventually mixed with the organic electron donor, may form a stable ink that can be printed by various techniques such as ink jet printing, slot-dye-coating etc.

The organic electron donor compound is according to the invention a conjugated polymer or oligomer, which is able to absorb light, in the visible and/or the infrared region, and to transport electron holes towards the electrode.

Different conjugated polymers are known as electron donors for use in the manufacture of solar cells. Preferred conjugated polymers include in particular poly-3-(hexyl-thiophene) (P3HT), poly[2-methoxy-5-(2'-ethylhexyloxy)-1,4-phenylene vinylene] (MEH-PPV), poly(9,9⊄-dioctylfluorene-*co*benzo-thiadiazole) (F8BT) and poly(2-methoxy-5-(3',7'-dimethyloctyloxy)-*p*-phenylene vinylene) (MDMO-PPV). Additionally, low band gap polymers such as [2,6-(4,4-bis(2-ethylhexyl)-4*H*-cyclopenta[2,1-b;3,4-b']-dithiophene)-*alt-*4,7-(2,1,3-benzothiadiazole)] (PCPDTBT) are preferred as organic electron donor compounds within the present invention. Pi-conjugated oligomers could be also used as donor material such as. dicyanovinyl (DCV)- substituted oligothiophenes bearing butyl side chains, or small molecules based on diketopyrrolopypyrrole and oligothiophene building blocks.

Methods for preparing such hybrid heterojunctions are known as such for instance from "Hybrid bulk heterojunction solar cells based on P3HT and porphyrin modified ZnO nanorods", A. J. Said, G. Poize,C. Martini, D. Ferry, W. Marine, S. Giorgio, F. Fages, J. Hocq, J. Bouclé, J. Nelson, J. R. Durrant, J. Ackermann, J. Phys. Chem. C, 2010, 114, 11273 and W.J.E. Beek, M. M. Wienk, M. Kemerink, X. Yang, R. A. J. Janssen, J. Phys. Chem. B. 2005, 109, 9505.

In particular, the nanocrystals may be dispersed into a solution of the electroactive surfactant, which is then blended with a conjugated polymer to form a bulk heterojunction structure, as described above.

The hybrid heterojunction thus formed may then be used to manufacture solar cells according to conventional techniques well known to the skilled person and described *inter alia* in the references cited above.

The invention will be explained more in detail in the following examples, and in view of the figures, which show:
- FIG.1:: Absorption spectra of P3HT and of composites comprising P3HT and ZnO nanorods prepared according to example 1, grafted with 0 to 5 wt% of PS-65;
- FIG.2:: Image obtained by transmission electronic microscope (TEM) of a P3HT/ZnO nanorod composite films made using ZnO nanorods with varying PS-65 grafting: (a) 0 wt.% PS-65, low magnification, (b) 1 wt% PS- 65, low magnification, (c) 0 wt.% PS-65, high magnification, (d) 1 wt% PS-65, high magnification, (e) 5 wt% PS-65, high magnification and (f) 10 wt% PS-65, high magnification;
- FIG.3:: Images obtained by atomic force microscope (AFM) (size: 2µmx2µm) of a P3HT/ZnO nanorod composite with varying PS-65 grafting: (a) 0 wt% PS-65, scale bar 120nm, Dz=120nm, rms roughness = 14.2nm (Dz = peak-to-peak height difference and rms = root mean square), (b) 1wt% PS-65, Dz = 90nm, rms roughness = 11.1 nm, (c) 5wt% PS-65, Dz = 76nm, rms roughness = 4.8 nm, (d) 10wt% PS-65, Dz = 72 nm, rms roughness = 4.2nm;
- FIG.4:: Traces of the current density against the voltage of ITO/PEDOT/P3HT:ZnO nanorod/Al photovoltaic devices manufactured using ZnO nanorods grafted with varying amount of PS-65;
- FIG.5:: **I**ncident-**P**hoton-to-electron **C**onversion **E**fficiency (IPCE) of ITO/PEDOT/P3HT:ZnO nanorod/Al photovoltaic devices manufactured using ZNO nanorods grafted with varying amount of PS-65;
- FIG.6:: Absorption spectra of P3HT and of composites comprising P3HT and ZnO nanorods prepared according to example 3, grafted with 0 to 1.5 wt% of DMC2T;
- FIG.7:: Traces of the current density against the voltage of ITO/PEDOT/P3HT:ZnO nanorod/Al photovoltaic devices prepared according to example 5A-F using ZnO nanospheres grafted with varying amount of DMC2T; and
- FIG.8:: Traces of the current density against the voltage of ITO/PEDOT/P3HT:ZnO nanorod/Al photovoltaic devices prepared according to example 5A-F using ZnO nanorods grafted with varying amount of DMC2T.

### [EXAMPLES]

### EXAMPLE 1 A-C

### NANOCOMPOSITE COMPRISING PS-65 COATED ZnO NANORODS

ZnO nanorods (50 nm average length) were prepared as follow. Zinc acetate (99.99 %), sodium hydroxide (99.998 %) were purchased from Aldrich and used without further purification, while methanol was distilled prior to use. The sodium hydroxide (288.8 mg, 7.22 mmol) and methanol (23 mL) were sonicated until a homogeneous dispersion was obtained. Zinc acetate (818.2 mg, 4,46 mmol), methanol (42 mL) and water (318 mL) were sonicated in a flask until completed dissolution and heated under stirring to 60°C. The sodium hydroxide solution was then added dropwise under argon atmosphere during 15-20 min. After 2 h and 15 min at 60 °C, the growth solution was condensed to 10 mL under reduced pressure at 55 °C and heated for 48 h at 60 °C. Methanol (50 mL) was added to the dispersion and the solution was stirred for 5 min. After decantation, the supernatant was removed and the solid residue washed 3 times with methanol. The resulting nanorods have an average size of 50 nm. The same procedure may be performed with KOH instead of NaOH.

In a suitable vessel, 20mg of ZnO nanorods were then introduced into 1ml of chloroform and thoroughly mixed. To the nanorod solution was then added 0 mg (EXAMPLE 1A), 0.2mg (EXAMPLE 1B), 1mg (EXAMPLE 1 C) and 2 mg (EXAMPLE 1D) of (2E)-2-cyano-3-(5'-{(E)-2-[4-(dibutylamino)phenyl]vinyl}-2,2'-bithien-5-yl)acrylic acid (PS-65) synthesized according to the procedure set out in J. Mawyin, I. Shupyk, M. Wang, G. Poize, P. Atienzar, T. Ishwara, J. R. Durrant, J. Nelson, D. Kanehira, N. Yoshimoto, C. Martini, E. Shilova, P. Secondo, H. Brisset, F. Fages, J. Ackermann. J. Phys. Chem. C, (2011), 115 (21), pp 10881-10888) as an electroactive surfactant (concentration 0 wt%, 1 wt%, 5 wt% and 10wt% with respect to the ZnO nanorods, respectively). In order to ensure complete grafting of the nanorods, the solution was further stirred for one hour at room temperature.

To the solution obtained was then added 10 mg of regioregular P3HT (available from Sigma-Aldrich) resulting in a ratio of 66 wt% ZnO with respect to the weight of the total mixture of P3HT and modified ZnO nanorods. Before further use, the mixed nanocomposite solution was sonicated at 50°C for 10min.

### EXAMPLE 2 A-F

### NANOCOMPOSITE COMPRISING DMC2T COATED ZnO NANOSPHERES

300mg of ZnO nanospheres (diameter 4-5 nm) prepared as follow. Zinc acetate (99.99 %), sodium hydroxide (99.998 %) were purchased from Aldrich and used without further purification, while methanol was distilled prior to use. In a typical synthesis, sodium hydroxide (288.8 mg, 7.22 mmol) and methanol (23 mL) were sonicated until a homogeneous dispersion was obtained. Zinc acetate (818.2 mg, 4,46 mmol), methanol (42 mL) and water (318 mL) were sonicated in a flask until completed dissolution and heated under stirring to 60°C. The sodium hydroxide solution was then added dropwise under argon atmosphere during 15-20 min. After 2 h and 15 min at 60 °C, nanospheres of 4-5 nm diameter were obtained and were then separated from the seed solution by several precipitation and washing steps using methanol.

20mg of ZnO spheres thus obtained were then transferred into a suitable vessel containing 0.8ml of chloroform and thoroughly stirred. 0 mg (EXAMPLE 2A), 0.2 mg (EXAMPLE 2B), 0.4 mg (EXAMPLE 2C), 0.6 mg (EXAMPLE 2D), 0.8 mg (EXAMPLE 2E) and 1 mg (EXAMPLE 2F) of DMC2T (synthesized as indicated in the US application filed under the reference number 61/391,880 and described in the application) was introduced into a suitable vessel containing 0.2ml of chloroform and thoroughly mixed. Then the solution containing the electroactive surfactant was added to the 20 mg ZnO solution in chloroform to give a concentration 0 wt%, 1 wt%, 2 wt%, 3 wt%, 4 wt% and 5 wt%, respectively, of the electroactive surfactant with respect to the ZnO nanospheres. In order to obtain complete grafting of the nanospheres, the solution was further stirred for 1 hour at room temperature.

To the solution obtained was then added 10 mg of regioregular P3HT (available from Sigma-Aldrich) resulting in a ratio of 66 wt% ZnO with respect to the weight of total mixture of P3HT and modified ZnO nanorods. Before further use, the mixed nanocomposite solution was sonicated in a water bath at 50 °C for 10min.

### EXAMPLE 3 A-F

### NANOCOMPOSITE COMPRISING DMC2T COATED ZnO NANORODS (50 nm) and P3HT

The Example 2 was repeated, but using ZnO nanorods (50 nm) prepared as in Example 1 and with a different mass ratio of DMC2T.

300mg of ZnO nanorods (50 nm) prepared as in Example 1 were separated from the seed solution by several precipitation and washing steps using methanol. 20mg of ZnO were then transferred into a suitable vessel containing 0.8ml of chloroform and thoroughly stirred. 0 mg (EXAMPLE 3A), 0.074 mg (EXAMPLE 3B), 0.148 mg (EXAMPLE 3C), 0.222 mg (EXAMPLE 3D), 0.296 mg (EXAMPLE 3E) and 1.48 mg (EXAMPLE 3F) of DMC2T (synthesized as indicated above) was introduced into a suitable vessel containing 0.2ml of chloroform and thoroughly stirred. Then the solution containing the electroactive surfactant was added to the 20 mg ZnO solution in chloroform to give a concentration 0 wt%, 0.37 wt%, 0.75 wt%, 1.125 wt%, 1.5 wt% and 7.5 wt%, respectively, of the electroactive surfactant with respect to the ZnO nanorods. In order to obtain complete grafting of the nanorods, the solution was further stirred for 1 hour at room temperature.

To the solution obtained was then added 10 mg of regioregular P3HT (available from Sigma-Aldrich) resulting in a ratio of 66 wt% of ZnO with respect to the weight of total mixture of P3HT and modified ZnO nanorods. Before further use, the mixed nanocomposite solution was sonicated in a water bath at 50 °C for 10min.

### EXAMPLE 4 A-D

### SOLAR CELL DEVICES

Solar cells were prepared by spin-coating on top of ITO glass substrate (sheet resistivity of 30 Ohm/SQ) a layer of about 100 nm of PEDOT:PSS (poly(ethylenedioxythiophene) : polystyrenesulfonate) (available from H-Starck, Germany) (speed 5000 rpm for 50 seconds). The substrate coated by the PEDOT:PSS layer was then annealed in air at 140 °C during 10 minutes.

The nanocomposite solutions prepared according to the preceding examples 1A to 1D, as indicated in table 1 below, were then spin coated on top of the PEDOT:PSS layer (speed 1500 rpm for 20 seconds) and left drying under argon.

Finally, electrodes were deposited on top of the nanocomposite layers by evaporation of aluminum (80 nanometers) under vacuum.

**Table 1: Composition of solar cells of example 4**

| **EXAMPLE** | **ZnO Nanocrystals** | **Length/ diameter** [nm] | **Electroactive surfactant** | **Surfactant concentration** [% wt] | **P3HT** [% wt] |
|---|---|---|---|---|---|
| 4A | Rods | 50 | PS-65 | 1 | 66 |
| 4B | Rods | 50 | PS-65 | 5 | 66 |
| 4C | Rods | 50 | PS-65 | 10 | 66 |
| * 4D* | Rods | 50 | PS-65 | 0 | 66 |

| | | | | | |
|---|---|---|---|---|---|
| *comparative example | | | | | |

### EXAMPLE 5 A-K

### SOLAR CELL DEVICES

Solar cells were prepared by spin-coating on top of an ITO glass substrate (sheet resistivity of 30 Ohm/SQ) a layer of about 100 nm of PEDOT:PSS (poly(ethylenedioxythiophene) : polystyrenesulfonate) (available from H-Starck, Germany) (speed 5000 rpm for 50 seconds). The substrate coated by the PEDOT:PSS layer was then annealed in air at 140 °C during 10 minutes.

The nanocomposite solution prepared in the preceding example 2A-2Fand 3A-3F as indicated in table 2 below, was then respectively spin-coated on top of the PEDOT:PSS layer (speed 1500 rpm for 20 seconds) and left drying under argon.

Finally, electrodes were deposited on top of the nanocomposite layers by evaporation of aluminum (80 nanometers) under vacuum.

**Table 2: Composition of solar cells of example 5**

| **EXAMPLE** | **ZnO Nanocrystals** | **Length/diameter** [nm] | **Electroactive surfactant** | **Concentration** [% wt] | **P3HT** [% wt] |
|---|---|---|---|---|---|
| **5A** | Spheres | 4-5 | DMC2T | 0 | 66 |
| **5B** | Spheres | 4-5 | DMC2T | 1 | 66 |
| **5C** | Spheres | 4-5 | DMC2T | 2 | 66 |
| **5D** | Spheres | 4-5 | DMC2T | 3 | 66 |
| **5E** | Spheres | 4-5 | DMC2T | 4 | 66 |
| **5F** | Spheres | 4-5 | DMC2T | 5 | 66 |
| **5G** | Rods | 50 | DMC2T | 0 | 66 |
| **5H** | Rods | 50 | DMC2T | 0,37 | 66 |
| **5I** | Rods | 50 | DMC2T | 0,75 | 66 |
| **5J** | Rods | 50 | DMC2T | 1,125 | 66 |
| **5K** | Rods | 50 | DMC2T | 1,5 | 66 |
| **5L** | Rods | 50 | DMC2T | 7,5 | 66 |

### [Characterization and Testing]

The structure and performance of the solar cells prepared according to example 4 and 5 was analyzed as follows.

### a. Absorption

The absorption spectra of the spin-coated films were recorded on a Varian 5000 UV-Vis-NIR spectrometer.

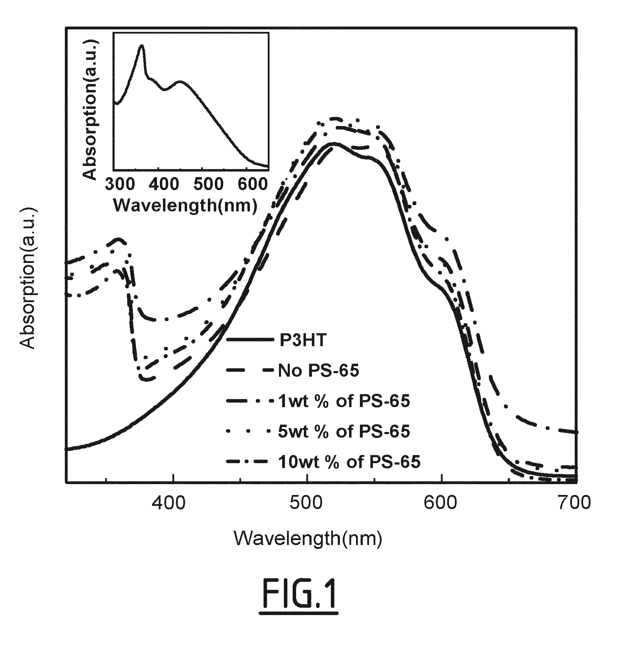

Fig.1 shows the absorption spectra of P3HT/ZnO nanorod composites according to example 1 using different ratios/percentages of PS-65. The insert shows the UV-vis absorption of PS-65. It can be seen that P3HT has a strong absorption in the visible between 400nm to 600 nm while ZnO nanorods have an absorption maximum around 360nm. The spectrum of the P3HT/ZnO nanorod composite consists of the overlapping absorption bands of P3HT and ZnO. PS-65 shows two absorption bands at 367 nm and 466 nm. The PS-65 modified P3HT/ZnO shows no apparent absorption characteristic to PS-65 since only a small amount of the molecule was used.

### b. Characterization using transition electron microscopy (TEM) and atomic force microscopy (AFM)

The TEM and AFM images of the composite films were obtained by using a JEOL-3010 microscope with an accelerating voltage of 120 kV. AFM (Nanoscope IIIA tapping mode multimode digital instrument) was used to characterize was used to characterize to roughness and thickness of P3HT/ZnO nanorod composites.

Transmission electron microscopy (TEM) and atomic force microscopy (AFM) where used to characterize the morphology of nanocomposites and the effect of PS65 in the dispersion of ZnO nanocrystals inside the P3HT matrix as obtained in example 1.

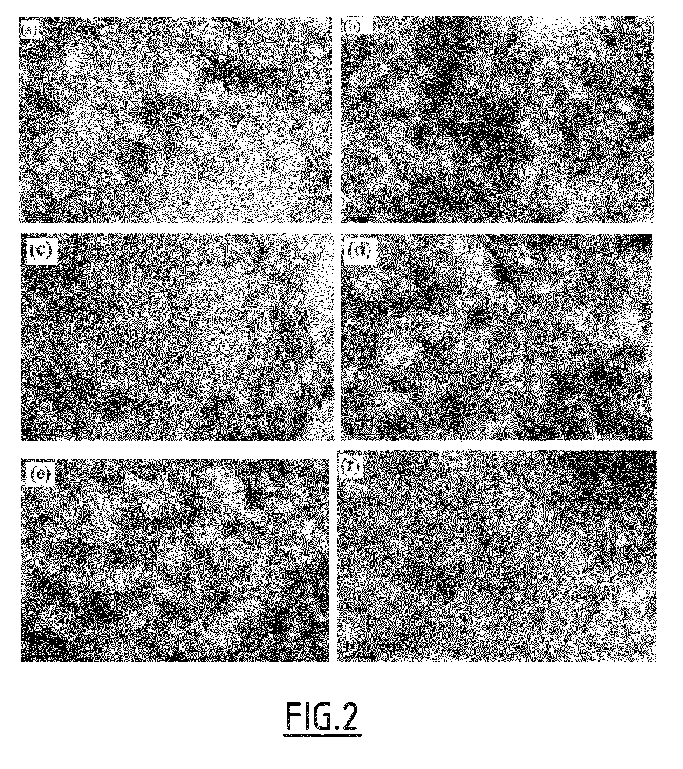

Films for TEM were obtained by spin-coating the samples onto 400 mesh copper grids. Fig.2(a) and Fig.2(b) show the TEM image of P3HT/ZnO nanorod composite without and with 1wt% PS-65 at higher magnification. These images show that the dispersion of nanorods in the polymer improves when the surfactant is added. The decrease in phase separation leads to an increase of the electron donor and acceptor interfacial area and improve the exciton dissociation efficiency in composite films. Fig.2(c)-Fig.2(f) show TEM images of P3HT/ZnO films with different amount of PS-65 at high magnification. Increasing the PS-65 concentration improves the homogeneity of the film and reduces the presence of aggregates as it can be seen in the TEM image.

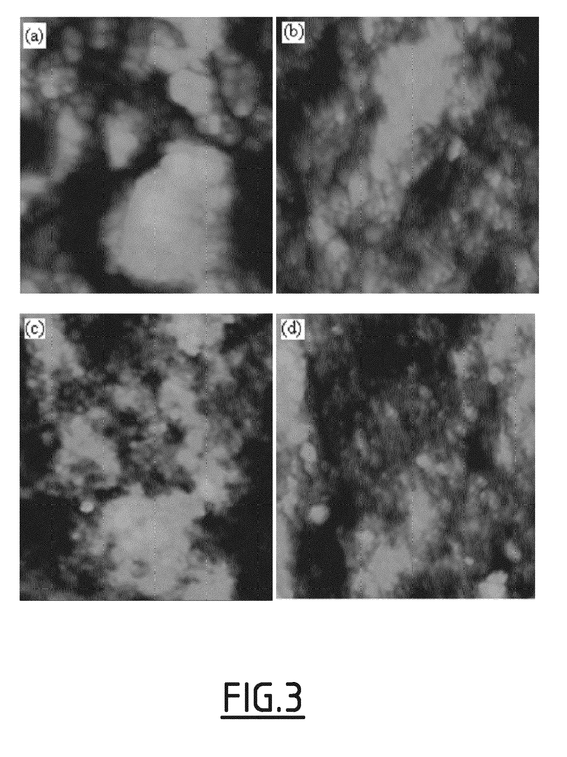

The improvements in dispersion observed with TEM can be correlated to the changes in surface roughness observed with AFM in tapping-mode and shown in Fig.3. The AFM images clearly show that P3HT/ZnO nanorod films obtained without electroactive surfactant (Fig.3(a)) contain large agglomerates in the films with a detrimental effect on the film roughness, while equivalent films obtained in presence of electroactive surfactant show a texture which indicates a better dispersion of the nanoparticles within the composite (Fig. 3(b)-fig.3(d)) and accordingly a notably lower roughness.

The calculated peak-to-peak roughness of the films is around 120nm, which indicates a likelihood of shunts since the film is relatively thin (200nm) as compared to the roughness. This explains the low open-circuit voltage measured when ZnO nanorods is used. Therefore, the addition of PS-65, even in small amounts (1wt %), can decrease the roughness of the films and the likelihood of shunts. After PS-65 modification of pure ZnO nanorod, the film root mean square (rms) roughness of P3HT/ZnO composite decreased from 14.2nm to 11.1nm, and the peak height difference Dz decreased from 120nm to 90nm. With the increase of PS-65 amount, AFM shows a lower surface roughness and better dispersion.

The collected TEM and AFM images show that the addition of PS-65 as a surfactant improves the two phase morphology and photovoltaic properties.

### c. Current-voltage

For the solar cells according to examples 4A-D, current-voltage (I-V) measurements were performed in the dark under Argon atmosphere in a glovebox and under 100 mW/cm² of AM1.5 illumination using a 150 W class AAA simulator from Oriel. The measured area of solar cell is 0.2cm². The solar energy conversion efficiency η is calculated as the ratio of the short circuit current *J_{sc}* times the open circuit voltage *V_{oc}* times the fill factor FF divided by the incident solar energy density, where FF is the ratio of the available power at the maximum power point *Pₘₐₓ* divided by *V_{oc}* and *J_{sc}*. External Quantum Efficiency measurements (EQE), which is the percentage of photons that are converted to electric current, were measured in air using a white-light halogen tungsten source combined with a Cornerstone monochromator with the spectral intensity calibrated using a reference silicon solar cell. The EQE values are obtained by measuring the photocurrent of the solar cell as a function of the wavelength of the light source.

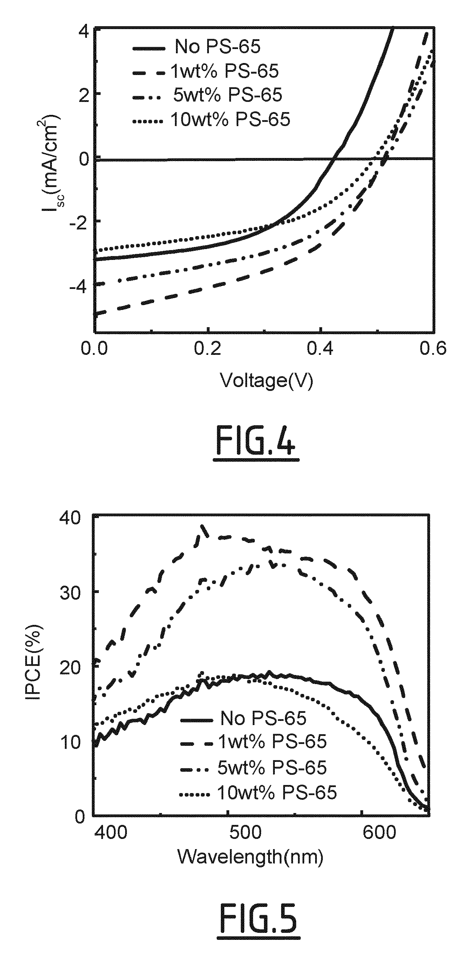

The I-V curves were obtained using a source calibrated to the AM 1.5 standard. (Fig.5a) shows the I-V curves of solar cells with only P3HT/ZnO and with PS65 surface modification (example 4 A-D). The photovoltaic parameters measured for the cells according to example 4 A-D are shown in Table 3. The addition of 1wt% of PS-65 increases both the short circuit current (Isc), open circuit voltage (Voc) of the devices as compared to pure P3HT/ZnO with a corresponding increase in efficiency (η) from 0.58 % to 1.12 % respectively.

However, further increase in concentrations of the surfactant reduces the photocurrent generation of the solar cells. Indeed, the characterized devices show that the photocurrent is highest for a surfactant concentration of 1 wt% while it decreases with higher concentrations (5 and 10 wt %). Therefore, a mass ratio around 1%wt appears presently the optimal concentration to improve the performance of the described devices.

### d. Current collection efficiency spectrum (IPCE)

Incident photon to current collection efficiency (IPCE) measurement equipment was assembled by Oriel products.

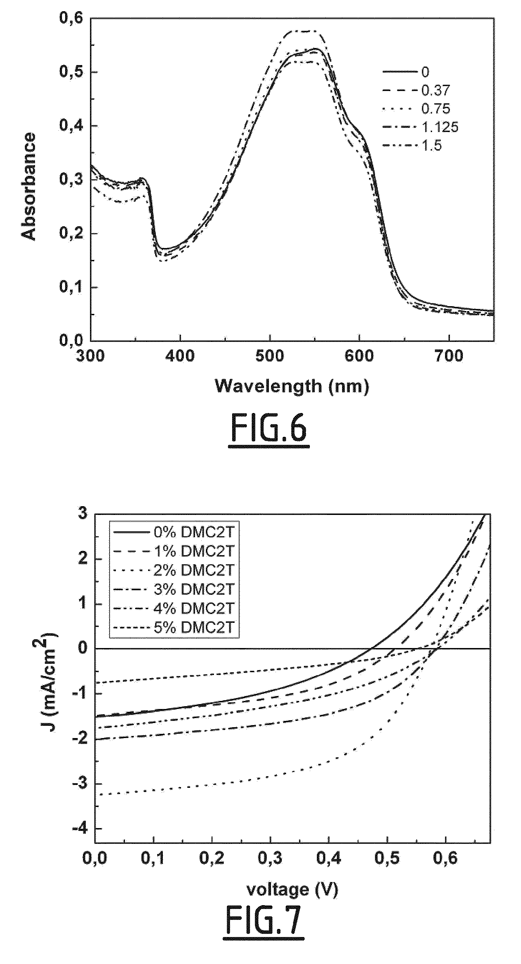

Fig.6 compares the IPCE spectrum of P3HT/ZnO devices with and without the PS-65 surfactant obtained according to example 4A-4D. It can be seen from Fig.6 that the IPCE of the prepared devices doubles in the range of 400nm to 650nm after 1 wt% PS-65 surfactant was added. The same trend observed in the IPCE as a function of the surfactant concentration correlate with the results obtained with the I-V characterization. Increasing the PS-65 concentration thus leads to a decrease in the IPCE.

**Table 3: Performance data of solar cells of example 4**

| **EXAMPLE** | **Ps65** [% wt] | **V_{oc}** (Volts) | **J_{sc}** (mA/cm²) | **F.F.** (%) | **Solar energy conversion efficiency** η (%) |
|---|---|---|---|---|---|
| **4A** | 1 | 0.51 | 4.9 | 45 | 1.12 |
| **4B** | 5 | 0.51 | 4 | 48 | 0.98 |
| **4C** | 10 | 0.49 | 2.9 | 48 | 0.68 |
| **4D** | 0 | 0.42 | 3.2 | 43 | 0.58 |

The external quantum efficiency measurements reflect the difference found in Jsc. The higher value of 23% at 500 nm in the case of nanospheres exceeds the value of nanorods by 35 %.

The solar cells of Example 5 were characterized in the glove-box under argon atmosphere. The results of the devices performance are shown in Table 4 A-B below.

Nanocomposite based DMC2T coated nanorods and nanospheres were blended with P3HT, and the corresponding thin films deposited by spin coating were characterized by absorption spectroscopy. Figure 6 shows the absorption spectra of P3HT/ZnO nanorod composites according to example 3 using different ratios/percentages of DMC2T. The spectrum of the P3HT/ZnO nanorod composite consists of the overlapping absorption bands of P3HT and ZnO. The DMC2T modified P3HT/ZnO shows no apparent change in absorption compared to unmodified P3HT/ZnO nanorod composites since only a small amount of the DMC-2T was used.

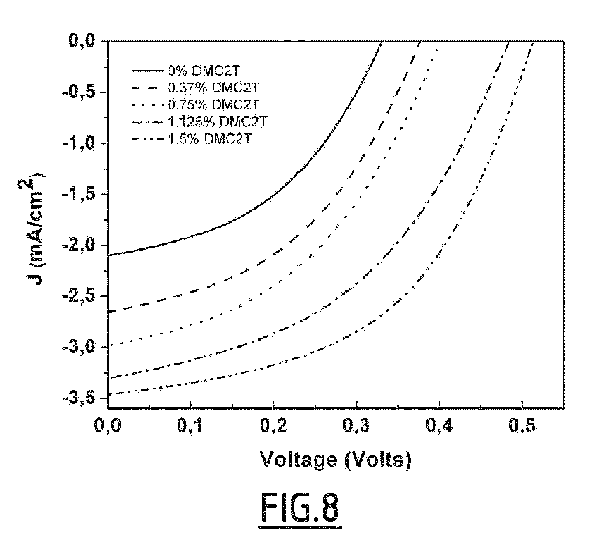

Nanocomposite based DMC2T coated nanorods and nanospheres blended with P3HT were used to produce bulk heterojunction solar cells. Figure 7 shows I-V curves of solar cells with only P3HT/ZnO nanospheres and with DMC2T surface modification according to example 5 A-F while Figure 8 shows the I-V curves of solar cells with only P3HT/ZnO nanorods and with DMC2T surface modification according to example 5 G-L. Table 4A and 4B resume the photovoltaic parameters of the best performing solar cells of example 5.

**Table 4A: Performance of solar cells made using nanospheres**

| **EXAMPLE** | **DMC2T** [%] | **V_{oc}** (Volts) | **J_{sc}** (mA/cm²) | **F.F.** (%) | η |
|---|---|---|---|---|---|
| **5A** | 0 | 0.48 | 1.51 | 38.88 | 0.28 |
| **5B** | 1.0 | 0.52 | 1.48 | 44.23 | 0.34 |
| **5C** | 2.0 | 0.58 | 3.25 | 56.41 | 1.00 |
| **5D** | 3.0 | 0.58 | 2.01 | 49.55 | 0.57 |
| **5E** | 4.0 | 0.58 | 1.76 | 40.62 | 0.41 |
| **5F** | 5.0 | 0.56 | 0.76 | 33.90 | 0.15 |

**Table 4B: Performance of solar cells made using nanorods**

| **EXAMPLE** | **DMC2T** [%] | **V_{oc}** (Volts) | **J_{sc}** (mA/cm²) | **F.F.** (%) | η |
|---|---|---|---|---|---|
| **5G** | 0.00 | 0.36 | 2.15 | 42.84 | 0.33 |
| **5H** | 0.37 | 0.40 | 2.61 | 43.61 | 0.45 |
| **5I** | 0.75 | 0.40 | 3.07 | 44.64 | 0.54 |
| **5J** | 0.115 | 0.48 | 3.44 | 45.54 | 0.75 |
| **5K** | 1.5 | 0.52 | 3.45 | 50.57 | 0.90 |
| **5L** | 7.5 | 0.66 | 0.8 | 30.5 | 0.15 |

The results show that the devices using the nanocomposite according to the invention instead of unmodified ZnO nanocrystals have improved efficiencies. The best efficiency was measured for solar cells prepared with ZnO nanospheres at 2 wt.% DMC2T (η=1%) and ZnO nanorods at 1.13 wt.% DMC2T (η=0.9%). In the case of nanospheres, the solar cells efficiency increased with the DMC2T concentration, reached a maximum at 2 wt.%, and decreased at higher DMC2T content. For the ZnO nanorods, the efficiency also increased up to 1%.

The preceding results show that the photovoltaic performance of P3HT/ZnO devices can be improved using ZnO nanocrystals of different shapes (spheres and rods) modified with an electroactive surfactant. Therefore, an electroactive surfactant such as PS-65 or DMC2T contributes to enhance the photoelectric efficiency of the hybrid P3HT/ZnO nanocrystal bulk heterojunction solar cells.

## Claims

1. Hybrid heterojunction comprising a conjugated polymer as donor and semiconductor nanocrystals as acceptor, wherein the semiconductor nanocrystals are grafted with up to 3% by weight of an electroactive surfactant whose LUMO level is lower than or equal to the LUMO level of the conjugated polymer and higher than or equal to the conducting band level of the semiconductor nanoparticles.

2. Hybrid heterojunction according to claim 1, wherein the conjugated polymer is derived from polythiophene.

3. Hybrid heterojunction according to claim 2, wherein the conjugated polymer is poly (3-hexylthiophene).

4. Hybrid heterojunction according to any of claims 1 to 3, wherein the semiconductor nanocrystals are of ZnO.

5. Hybrid heterojunction according to any of claims 1 to 4, wherein the semiconductor nanocrystals are elongated nanocrystals.

6. Hybrid heterojunction according to any of claims 1 to 5, wherein the electroactive surfactant carries a carboxylic moiety and/or a tertiary amine group at a terminal position.

7. Hybrid heterojunction according to any of claims 1 to 6, wherein the electroactive surfactant is a conjugated molecule.

8. Hybrid heterojunction according to any of claims 1 to 6, wherein the electroactive surfactant comprises at least one thiophene moiety.

9. Hybrid heterojunction according to any of claims 1 to 6, wherein the electroactive surfactant carries cyano group in α-position to the carboxylic moiety.

10. Hybrid heterojunction according to any of claims 1 to 6, wherein the electroactive surfactant carries a tertiary amine group at a terminal position.

11. Hybrid heterojunction according to any of claims 1 to 10, wherein the semiconductor nanocrystals are grafted with between 0.01% and 2% by weight of electroactive surfactant, with respect to the weight of the semiconductor.

12. Solar cells comprising a hybrid heterojunction according to any of the claims 1 to 11.

13. Process for the manufacture of a hybrid heterojunction comprising a conjugated polymer and semiconductor nanocrystals grafted with an electroactive surfactant, comprising the steps consisting of:
(i) dispersing the semi-conductor nanocrystals into a suitable solvent;
(ii) mixing the electroactive surfactant in an amount of up to 3 wt%, with respect to the weight of the nanocrystals, said surfactant being optionally dissolved in a suitable solvent, with the dispersion obtained in step (i) and stirring the solution to obtain semiconductor nanocrystals grafted with electroactive surfactant;
(iii) mixing with a suitable quantity of a conjugated polymer;
(iv) preparing a film of the mixture; and
(v) evaporating the solvent.
